# EUROPEAN PATENT APPLICATION

(11) **EP 2 113 812 A1**
(43) Date of publication of application: **04.11.2009**
(21) Application number: 09005117.8
(22) Date of filing: 07.04.2009
(51) Int. Cl.: G03F 7/20

(54) **Exposure apparatus and device manufacturing method**

(30) Priority: 28.04.2008 JP 2008117293
(71) Applicant: Canon Kabushiki Kaisha, Tokyo (JP)
(72) Inventor: Chibano, Takahito, Ohta-ku Tokyo (JP); Nakano, Hitoshi, Ohta-ku Tokyo (JP)
(74) Representative: Weser, Wolfgang

(57) **Abstract**

An exposure apparatus that exposes a substrate (6) through liquid (18) includes a projection optical system (4) that projects a pattern of an original (2) onto the substrate; a supply port (12) that supplies the liquid; a recovery port (13) that recovers the liquid; and a plurality of pressure resistance portions (22, 24, 25, 27) arranged at a passage of at least one of the supply port and the recovery port, to apply pressure resistances to the liquid passing through the passage. The pressure resistance portions surround a final surface of the projection optical system and are distant from each other in a direction in which the liquid flows through the passage. One of the plurality of pressure resistance portions, which is nearest to the substrate, faces the substrate.

## Description

### BACKGROUND OF THE INVENTION

### Field of the Invention

The present invention relates to an exposure apparatus that exposes a substrate through liquid, and a device manufacturing method using the exposure apparatus.

### Description of the Related Art

In a manufacturing process for a semiconductor device, such as a large scale integration (LSI) device or a very large scale integration (LSI) device, having an extremely fine pattern, a reduction projection exposure apparatus has been used, in which a pattern formed on a mask is projected in a reduced manner onto a substrate with a photoresist applied thereon. The pattern is desired to be smaller as an integration density of the semiconductor device is increased. The exposure apparatus works on a further smaller pattern as a resist process progresses.

A resolution of the exposure apparatus is typically increased by decreasing an exposure wavelength, or by increasing a numerical aperture (NA) of a projection optical system.

Regarding the exposure wavelength, the trend shifts from a KrF excimer laser with an oscillation wavelength of about 248 nm to an ArF excimer laser with an oscillation wavelength of about 193 nm. A fluorine (F₂) excimer laser with an oscillation wavelength of about 157 nm is also developed.

Meanwhile, a different approach of the technique for increasing the resolution may be an immersion method. In an existing method using gas, a space between a final surface of the projection optical system and a surface of an exposure-object substrate (for example, wafer) is filled with gas. In the immersion method, projection and exposure are performed while the space is filled with liquid. The immersion method has an advantage of increasing the resolution. For example, when immersion liquid is pure water (with a refractive index of 1.44) and it is assumed that a maximum incident angle of a light beam to form an image on a wafer in the immersion method is equivalent to that in the existing method using gas, the resolution in the immersion method is 1.44 times the resolution in the existing method using gas even when both the methods use light sources with equivalent wavelengths. This provides the same result as though the numerical aperture of the projection optical system in the existing method using gas is increased 1.44 times, although the numerical aperture cannot be 1 or larger in the existing method using gas. With the projection optical system, a resolution of NA = 1 or larger can be provided.

To fill the space between the final surface of the projection optical system and the water surface with liquid, two methods may be used. In one method, the final surface of the projection optical system and the entire wafer are arranged in a liquid container. The other method is a local-fill method in which liquid is provided only in a space between the final surface of the projection optical system and the water surface.

In an exposure apparatus using the local-fill method, the liquid held in the space between the final surface of the projection optical system and the water surface has to be continuously held in the space even when a wafer stage which retains the wafer is driven. In addition, the liquid has to be held in the space during driving of the stage in any direction, for example, during exposure or stepping, or during various measurement or movement to a measurement position. In light of the situation, Japanese Patent Laid-Open No. 2005-019864 discloses a method of evenly supplying liquid from the entire periphery of a final surface of a projection optical system and recovering the liquid.

In particular, a configuration is disclosed in which a supply port (supply nozzle) for supplying liquid and a recovery port (recovery nozzle) are provided at the entire periphery of the final surface of the projection optical system. In addition, Japanese Patent Laid-Open No. 2005-019864 discloses that a porous plate or a porous material having a plurality of small holes are provided at a nozzle opening of the supply nozzle or the recovery nozzle in order to reduce local unevenness in supply amount or recovery amount.

Further, Japanese Patent Laid-Open No. 2005-347617 and Japanese Patent Laid-Open (Translation of PCT Application) No. 2006-523029 disclose a configuration in which a plurality of holes or openings are formed in a nozzle member surrounding a final surface of a projection optical system.

However, in a case where the porous plate is provided at the supply port, since the liquid is supplied from the entire periphery of the final surface of the projection optical system, a flow rate of the liquid passing through a through hole is increased if a hole diameter of the through hole of the porous plate is decreased, resulting in a force to be applied to a wafer or a wafer stage becoming extremely large. The wafer is likely deformed, and a control performance of the wafer stage is deteriorated. Further, since the flow rate of the liquid to be discharged from the supply port is high, the flow of the liquid in the space between the projection optical system and the wafer surface is disordered, resulting in an exposure defect being increased. To prevent this, if the hole diameter of the through hole is increased, a pressure resistance applied by the porous plate to the flow of the liquid is decreased, and thus the liquid is not evenly supplied from the entire periphery of the final surface of the projection optical system. Owing to this, the liquid is not sufficiently held during driving of the wafer stage, and bubbles may be mixed into the liquid.

In a case where the porous plate is provided at the recovery port, since the liquid is recovered to the entire periphery of the final surface of the projection optical system, the flow rate of the liquid passing through the through hole is decreased if a hole diameter of the through hole is small, resulting in the flow of the liquid in the space between the projection optical system and the wafer surface being disordered and the exposure defect being increased. To prevent this, if the hole diameter is increased, a pressure resistance applied by the porous plate to the flow of the liquid is decreased, the recovery of the liquid to the entire periphery of the final surface of the projection optical system becomes uneven, and the liquid is no longer sufficiently held during driving of the wafer stage.

### SUMMARY OF THE INVENTION

The present invention provides an exposure apparatus capable of supplying and recovering liquid substantially evenly from the entire periphery of a final surface of a projection optical system, and reducing occurrence of an exposure defect.

The present invention in its first aspect provides an exposure apparatus as specified in claims 1 to 10.

The present invention in its second aspect provides a device manufacturing method as specified in claim 11.

With the exposure apparatus according to the aspect of the present invention, in the immersion exposure apparatus in which the space between the projection optical system and the substrate is filled with the liquid, the liquid can be substantially evenly supplied and recovered from and to the entire periphery of the final surface of the projection optical system, and the occurrence of the exposure defect can be reduced. Accordingly, exposure of a desirable exposure pattern can be provided.

Further features of the present invention will become apparent from the following description of exemplary embodiments with reference to the attached drawings.

### BRIEF DESCRIPTION OF THE DRAWINGS

Fig. 1 is a side view showing structure of an exposure apparatus according to a first embodiment of the present invention.

Fig. 2 is a side view showing structure in an area near a supply port and a recovery port formed at a nozzle of the exposure apparatus according to the first embodiment.

Fig. 3 is a side view showing structure in an area near a supply port and a recovery port formed at a nozzle of an exposure apparatus according to a second embodiment of the present invention.

Fig. 4 is a plan view showing a lower side of the nozzle and an optical element of the exposure apparatus according to the second embodiment.

Fig. 5 is an enlarged cross-sectional view showing an area near the supply port formed at the nozzle of the exposure apparatus according to the second embodiment.

Fig. 6 is a pressure distribution diagram of liquid in an area below a first pressure resistance portion and above a second pressure resistance portion according to the second embodiment.

Fig. 7 is a pressure distribution diagram of liquid in an area below the second pressure resistance portion and above a wafer according to the second embodiment.

Fig. 8 is an enlarged cross-sectional view showing an area near the recovery port formed at the nozzle of the exposure apparatus according to the second embodiment.

Fig. 9 is a side view showing structure in an area near a supply port and a recovery port formed at a nozzle of an exposure apparatus according to a third embodiment of the present invention.

Fig. 10 is a plan view showing a lower side of the nozzle and an optical element of the exposure apparatus according to the third embodiment.

### DESCRIPTION OF THE EMBODIMENTS

Various embodiments of the present invention are described below with reference to the attached drawings. Like reference marks refer to like items in the various embodiments and drawings.

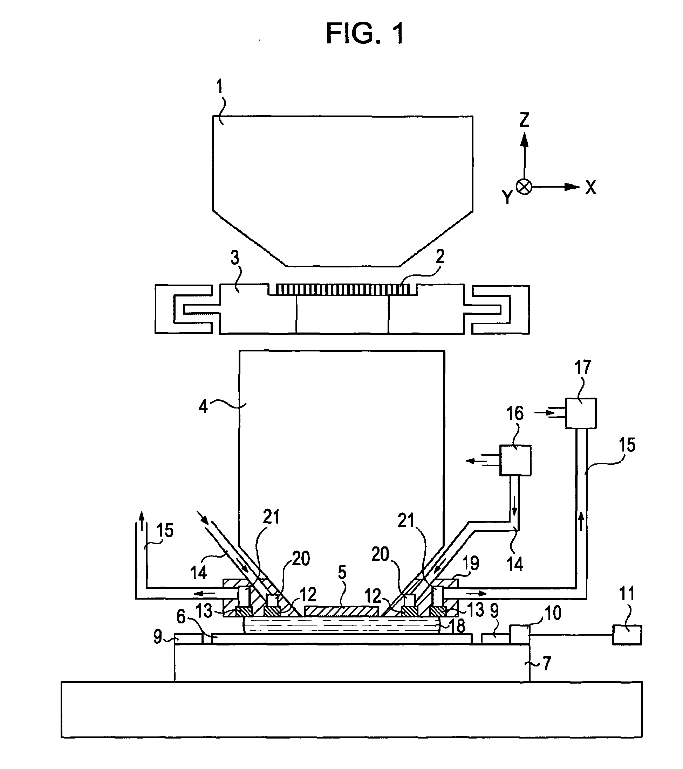

Fig. 1 is a side view schematically showing a step-and-scan projection exposure apparatus according to a first embodiment of the present invention. In Fig. 1, light emitted from an exposure light source (not shown), such as an ArF excimer laser or an F₂ excimer laser, is provided to an illumination optical system 1. Using light provided by the exposure light source, the illumination optical system 1 illuminates a part of a reticle (original) 2 with slit light (light having a cross section obtained such as when passing through a slit). During the illumination of the reticle 2 with the slit light, a reticle stage (original stage) 3 that retains the reticle 2 and a wafer stage (substrate stage) 7 that retains a wafer (substrate) 6 scan while one of the stages is in synchronization with the other. By the synchronous scanning, a pattern on the reticle 2 is entirely and continuously formed on the wafer 6 through a projection optical system 4, and a resist applied on a surface of the wafer 6 is exposed to light.

Referring to Fig. 1, an X-direction measurement mirror 10 is fixed to the wafer stage 7. An X-direction laser interferometer 11 measures a position of the wafer stage 7 in an X-direction. Similarly in a Y-direction, a Y-direction measurement mirror (not shown) is fixed to the wafer stage 7. A Y-direction laser interferometer (not shown) measures a position of the wafer stage 7 in the Y-direction. Thusly, the position of the wafer stage 7 is measured. In addition, the reticle stage 3 is provided with a measurement mirror (not shown). A laser interferometer (not shown) measures a position of the reticle stage 3. Thusly, the position of the reticle stage 3 is measured.

The position of the reticle stage 3 and the position of the wafer stage 7 are measured in real time. Using the measurement values, a control device (not shown) performs positioning and synchronization control of the reticle 2 and the water 6. The wafer stage 7 contains a driving device that adjusts, changes, or controls a position in an up-down direction (Z-direction), a rotation direction, and an inclination of the wafer 6. During the exposure, the driving device controls the wafer stage 7 such that an exposure region on the wafer 6 is constantly aligned with a focal plane of the projection optical system 4 with high accuracy. Here, the position (position in the up-down direction and inclination) of an exposure plane on the wafer 6 is measured by an optical focus sensor (not shown), and is provided to the control device (not shown).

A space surrounding the wafer stage 7 and an area near a final lens of the projection optical system 4 is a substantially sealed space. The space is supplied with gas at predetermined temperature and humidity from a gas-conditioning device (not shown). Accordingly, the space surrounding the wafer stage 7 and the area near the final lens is maintained at a predetermined temperature. Similarly, a space surrounding the reticle stage 3 is a substantially sealed space, which is supplied with conditioned gas. Accordingly, the space around the reticle stage is maintained at a predetermined temperature.

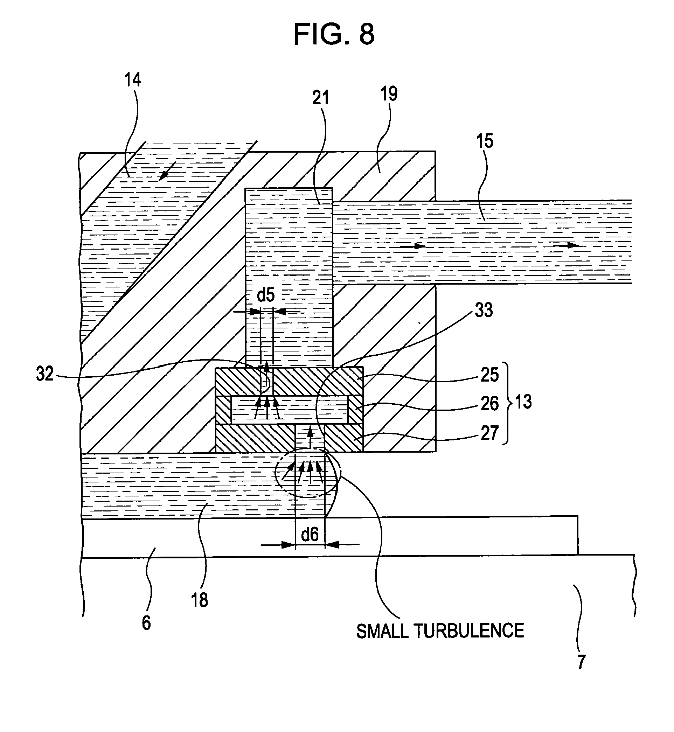

A nozzle 19 surrounds an optical element 5 at the final surface of the projection optical system 4. The nozzle 19 includes a supply port 12 (described later in detail) to surround the outer periphery of the optical element 5 and to face the wafer 6. Liquid 18 is supplied through the supply port 12 to a space between the optical element 5 and the wafer 6. A buffer space 20 is provided above the supply port 12 so that the liquid 18 supplied though a supply tube 14 is applied to the entire periphery of the supply port 12. The buffer space 20 is connected to a liquid supply device 16 through the supply tube 14. The nozzle 19 also includes a recovery port 13 (described later in detail) to surround the optical element 5 and the supply port 12 and to face the wafer 6. The liquid 18 and gas are recovered through the recovery port 13. Here, a mechanism of the recovery port 13, through which the gas is recovered in addition to the liquid 18, is described. Immediately after the supply of the liquid 18 through the supply port 12 is started, the space between the optical element 5 and the water 6 is not filled with the liquid 18. In this state, the gas in the space is recovered through the recovery port 13. When the space is filled with the liquid 18, the liquid 18 is continuously supplied through the supply port 12, and is simultaneously recovered through the recovery port 13. Hence, the space is filled with the liquid 18 only in an area near the recovery port 13 (see Fig. 1 or 8). An interface appears between the liquid 18 and ambient gas at a position near the recovery port 13. The liquid 18 and the ambient gas around the liquid 18 are recovered through the recovery port 13.

A buffer space 21 is provided above the recovery port 13 to surround the optical element 5 and the supply port 12 in a similar manner to the supply port 12. The buffer space 21 is connected to a liquid/gas recovery device 17 through a recovery tube 15. Referring to Fig. 1, the supply tube 14 connected to the buffer space 20 and the recovery tube 15 connected to the buffer space 21 are illustrated in the same plane (in a ZX plane perpendicular to the wafer 6) for easier understanding. The supply tube 14 and the recovery tube 15 do not have to be provided in the same plane, and may be arranged in different planes as long as the planes are perpendicular to the wafer 6.

For example, the liquid supply device 16 may include a pump device that pumps the liquid 18, and a flow-rate control device that controls a supply flow rate of the liquid 18. The liquid supply device 16 may further include a temperature control device that controls a supply temperature of the liquid 18. For example, the liquid/gas recovery device 17 may include a tank that separates the recovered liquid 18 from the gas and temporarily stores the liquid 18, a sucking device that sucks the liquid 18 and the gas, and a flow-rate control device that controls a recovery flow rate of the liquid 18 and the gas.

The liquid 18 for an immersion exposure apparatus employs a type with a small absorptivity of exposure light. In particular, pure water, functional water, or fluoro liquid (e.g., fluorocarbon) may be used.. Dissolved gas should be effectively removed in advance from the liquid 18 by a degassing device (not shown). This is for preventing bubbles from being produced. Even when bubbles are produced, the liquid 18 can absorb the bubbles. For example, in a case where target dissolved gas is nitrogen and oxygen contained in the ambient gas by a large amount, the bubbles can be reliably prevented from being produced as long as the gas dissolvable into the liquid 18 is removed by 80% or higher. Alternatively, the degassing device (not shown) may be provided at the exposure apparatus, so that the liquid 18 is supplied to the liquid supply device 16 while the dissolved gas in the liquid 18 is constantly removed. For example, the degassing device may be a vacuum degassing device in which the liquid 18 flows from a first section to a second section through a gas-permeable film, the first section is evacuated, and dissolved gas contained in the liquid 18 is removed to the evacuated first section through the film.

A liquid support plate 9 having a height substantially the same as a height of the wafer 6 is provided to surround the wafer 6. The liquid support plate 9 supports the liquid 18 in the space between the optical element 5 and the wafer 6 even at an end portion of the wafer 6. Accordingly, exposure can be performed at the end portion of the wafer 6.

The nozzle 19, the liquid support plate 9, the supply port 12, and the recovery port 13 are made of, for example, stainless steel, fluorocarbon resin, or ceramic, which is hard to contaminate and hence easily keeps its cleanliness.

The liquid 18 is supplied to the space between the optical element 5 and the water 6 through the supply port 12 in a direction substantially perpendicular to the wafer 6 or the liquid support plate 9. Thus, the liquid 18 can be efficiently supplied during driving of the wafer stage 7 in any direction. The liquid 18 is recovered from the space between the optical element 5 and the water 6 using the recovery port 13. Fig. 1 illustrates that the liquid 18 is recovered through the recovery port 13 in a direction perpendicular to the wafer 6. However, the direction of the recovery port 13 is not limited thereto. The liquid 18 may be recovered obliquely upward with respect to the wafer 6.

Fig. 1 illustrates that bottom planes of the optical element 5, supply port 12, recovery port 13, and nozzle 19 facing the wafer 6 are arranged at the same height. However, the positional relationship is not limited thereto. These parts may be arranged at different heights.

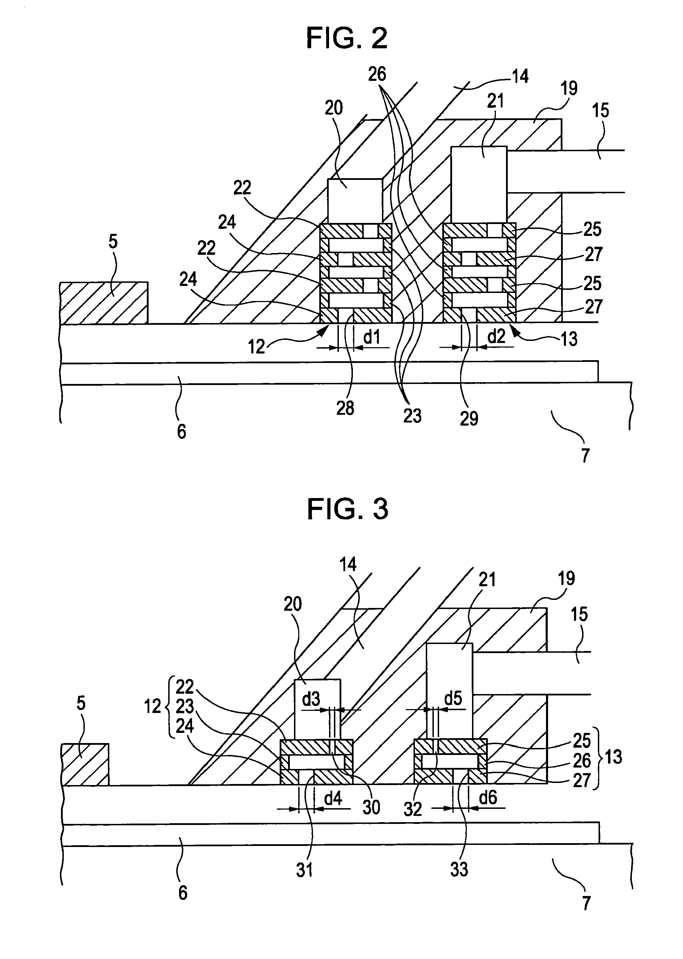

Fig. 2 is a configuration diagram showing an area near the supply port 12 and the recovery port 13 formed at the nozzle 19 according to the first embodiment. For easier understanding, the liquid 18 is not illustrated in Fig. 2.

Referring to Fig. 2, the supply port 12 includes a first pressure resistance portion 22, a second pressure resistance portion 24, and a first spacer 23. The first and second pressure resistance portions 22 and 24 apply pressure resistances to the liquid 18 passing therethrough. Herein, two first pressure resistance portions 22 and two pressure second pressure resistance portions 24 are alternately arranged at the supply port 12. Each first pressure resistance portion 22 is formed of a porous plate in which a plurality of through holes 28 having a hole diameter d1 are formed. Similarly to the first pressure resistance portion 22, each second pressure resistance portion 24 is formed of a porous plate in which a plurality of through holes 28 having a hole diameter d1 are formed. One of the through holes 28 is illustrated in Fig. 2. The other through holes 28 have the same structure as the illustrated through hole 28.

In this embodiment, the hole diameter d1 and number of the through holes 28 of the first pressure resistance portion 22 are equivalent to those of the second pressure resistance portion 24. The through holes of the first pressure resistance portion 22 are arranged so as not to be overlapped with the through holes of the second pressure resistance portion 24 in the direction perpendicular to the wafer 6. The positional relationship of the through holes is not limited to that shown in Fig. 2, as long as the through holes of the two adjacent porous plates are not overlapped with each other in the direction perpendicular to the wafer 6.

The porous plate can apply a desirable pressure resistance to the liquid 18 when the liquid 18 passes through the porous plate by optimizing the hole diameter, number, length, and shape of the through holes. Thus, the hole diameter, number, length, and shape of the through holes of the porous plate can be desirably determined so that a desirable pressure resistance is applied to the liquid 18 in accordance with an arrangement space of the supply port 12 and the recovery port 13. Hence, the apparatus can be further freely designed.

The hole diameter d1 and number of the through holes 28 are determined so as to effectively reduce a turbulence of a flow of the liquid 18 supplied to the space between the optical element 5 and the water 6 through the through holes 28. To reduce the turbulence of the flow of the liquid 18, it is necessary to increase the hole diameter d1 of the through holes 28 or the number of the through holes 28. When only a single porous plate is used, for example, if a hole diameter d1 of the through holes 28 is increased, it is difficult to supply the liquid 18 to the entire buffer space 20. Hence, the liquid 18 is not supplied substantially evenly from the entire periphery of the supply port 12. In contrast, the plurality of porous plates, which are arranged at a distance in a flow direction of the liquid 18 through the supply port 12, are arranged in this embodiment. Accordingly, a desirable pressure resistance can be applied to the liquid 18. Further, the through holes of the adjacent first and second pressure resistance portions 22 and 24 are arranged so as not to be overlapped with each other in the direction perpendicular to the wafer 6. Accordingly, a distance by which the liquid 18 flows through the supply port 12 is increased, and hence, the pressure resistance can be further reliably applied to the liquid 18. With this configuration, the liquid 18 is supplied to the entire buffer space 20, and the liquid 18 can be supplied evenly from the entire periphery of the supply port 12. Further, since the desirable pressure resistance is applied to the liquid 18, the wafer 6 or the wafer stage 7 does not receive a high pressure. Thus, the flow of the liquid 18 is less disordered in the space between the optical element 5 and the water 6.

Similarly to the supply port 12, the recovery port 13 has four pressure resistance portions that apply pressure resistances to the liquid 18 passing therethrough. In particular, the recovery port 13 includes two third pressure resistance portions 25, two fourth pressure resistance portions 27, and second spacers 26 configured to regulate gaps between the third and fourth pressure resistance portions 25 and 27. A pressure resistance to be applied to the liquid 18, gas, or both passing through the recovery port 13 is adjusted to a desirable value by the two third pressure resistance portions 25 and the two fourth pressure resistance portions 27. The third pressure resistance portions 25 and the fourth pressure resistance portions 27 are formed of porous plates in which a plurality of through holes 29 having a hole diameter d2 are made, and are alternately arranged. The through holes of the two adjacent porous plates are arranged so as not to be overlapped with each other in the direction perpendicular to the wafer 6. With this configuration, similarly to the supply port 12, in the recovery port 13, the flow of the liquid 18 is less disordered in the space between the optical element 5, and the wafer 6 and the liquid 18 can be evenly recovered to the entire periphery of the recovery port 13.

With the exposure apparatus of this embodiment, the hole diameter and number of the through holes of the first pressure resistance portion 22 are equivalent to those of the second pressure resistance portion 24, the first and second pressure resistance portions 22 and 24 being arranged at the supply port 12. The hole diameter and number of the through holes 28 are determined so as to effectively reduce the turbulence of the flow of the liquid 18 supplied through the through holes 28. Thus, a pressure resistance applied by a single pressure resistance portion to the liquid 18 is decreased. In this embodiment, the four pressure resistance portions are provided to obtain a desirable pressure resistance, however, more than four pressure resistance portions may be required depending on a pressure resistance to be applied. The arrangement space of the pressure resistance portions may be increased in size. When the arrangement space is increased in size, the apparatus may be increased in size. This is a common matter to the recovery port 13. In particular, when more pressure resistance portions are required at the recovery port 13, the exposure apparatus may be increased in size. In a second embodiment (described later in detail), an exposure apparatus dealing with the matter is described.

In this embodiment, the pressure resistance portions are arranged at both the supply port 12 and the recovery port 13. However, the pressure resistance portions do not have to be provided at both. The pressure resistance portions may be arranged at one of the supply port 12 and the recovery port 13.

Further, in this embodiment, the recovery port 13 is formed to surround both the optical element 5 and the supply port 12. However, the position of the supply port 12 and the position of the recovery port 13 may be switched. That is, a recovery port 13 may be arranged inside a supply port 12, and the supply port 12 may be provided to surround the optical element 5 and the recovery port 13. The same can be said to the following embodiments.

Fig. 3 is a configuration diagram of an area near a nozzle 19 showing the details of a supply port 12 and a recovery port 13 of an exposure apparatus according to a second embodiment of the present invention. In the first embodiment, the four pressure resistance portions are provided at each of the supply port 12 and the recovery port 13. In this embodiment, two pressure resistance portions are provided at each port. For easier understanding, liquid 18 is not illustrated in Fig. 3.

Referring to Fig. 3, the supply port 12 includes a first pressure resistance portion 22 and a second pressure resistance portion 24 configured to apply pressure resistances to the liquid 18 passing therethrough, and a first spacer 23 configured to regulate a gap therebetween. The pressure resistance applied to the liquid 18 when the liquid 18 passes through the supply port 12 is adjusted to a desirable value by the first and second pressure resistance portions 22 and 24. The first pressure resistance portion 22 is formed of a porous plate in which a plurality of through holes 30 having a hole diameter d3 are formed. Similarly, the second pressure resistance portion 24 is formed of a porous plate in which a plurality of through holes 31 having a hole diameter d4 are formed.

Similarly to the supply port 12, the recovery port 13 has two pressure resistance portions that apply pressure resistances to the liquid 18 passing therethrough. In particular, the recovery port 13 includes a third pressure resistance portion 25, a fourth pressure resistance portion 27, and a second spacer 26 configured to regulate a gap therebetween. A pressure resistance to be applied to the liquid 18, gas, or both passing through the recovery port 13 is adjusted to a desirable value by the third and fourth pressure resistance portions 25 and 27. The third pressure resistance portion 25 is formed of a porous plate in which a plurality of through holes 32 having a hole diameter d5 are formed. Similarly, the fourth pressure resistance portion 27 is formed of a porous plate in which a plurality of through holes 33 having a hole diameter d6 are formed.

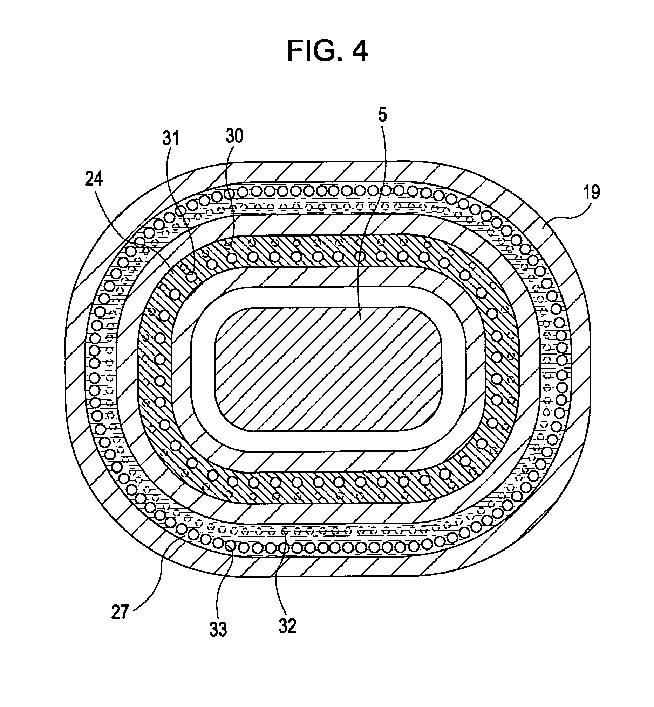

Fig. 4 is a plan view showing a lower side of the nozzle 19 and the optical element 5 according to the second embodiment. In particular, Fig. 4 is a configuration diagram showing a positional relationship of the through holes 30, 31, 32, and 3 of the pressure resistance portions 22, 24, 25, and 27 of the supply port 12 and the recovery port 13.

Referring to Fig. 4, the plurality of through holes 31 are formed in the second pressure resistance portion 24 to surround the optical element 5 to surround the optical element 5 (in Fig. 4, only a single through hole is marked with the reference mark 31 for easier understanding). Similarly, the plurality of through holes 30 (broken lines) are formed in the first pressure resistance portion 22 (in Fig. 4, only a single through hole is marked with the reference mark 30 for easier understanding in a manner similar to the through hole 31). The through holes 30 and 31 are arranged so as not to be overlapped with each other when viewed from the lower side of the nozzle 19. The positional relationship between the through holes 30 and 31 is not limited to that shown in Fig. 3 as long as the through holes 30 and 31 are not overlapped with each other in a direction perpendicular to the wafer 6.

The plurality of through holes 32 (broken lines) and 33 are formed in the third and fourth pressure resistance portions 25 and 27 to surround the optical element 5 and the first and second pressure resistance portions 22 and 24. Similarly to the positional relationship between the through holes 30 and 31, the through holes 32 and 33 are arranged so as not to be overlapped with each other when viewed from the lower side of the nozzle 19.

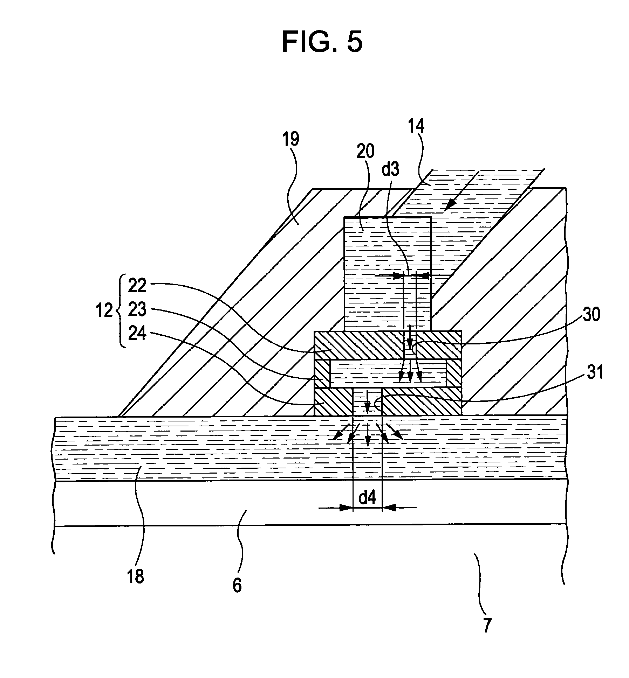

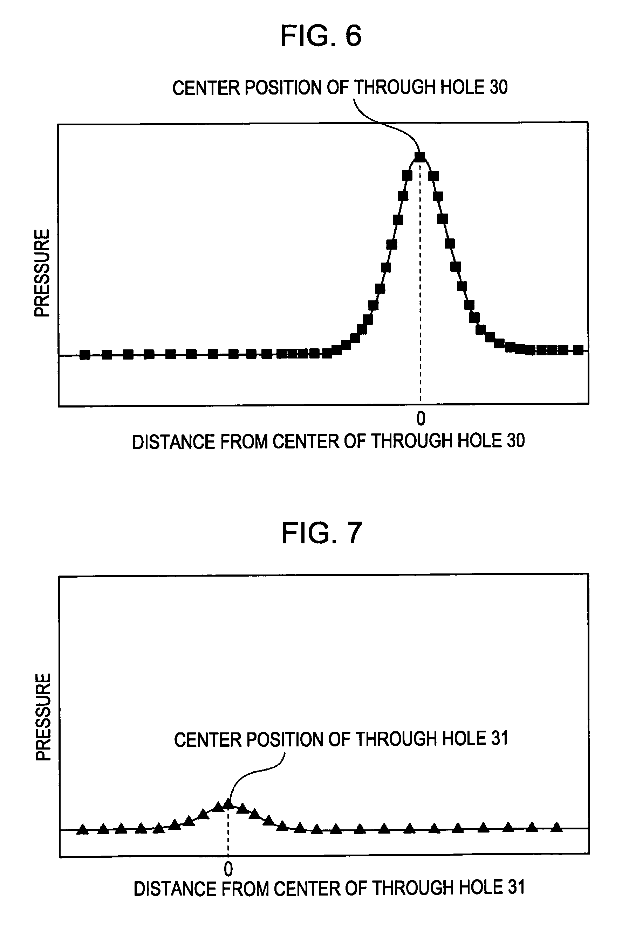

Herein, referring to Figs. 5, 6, and 7, the first and second pressure resistance portions 22 and 24 provided at the supply port 12 are described. Fig. 5 is an enlarged cross-sectional view showing an area near the supply port 12 formed at the nozzle 19 according to the second embodiment. Fig. 6 is a pressure distribution diagram of the liquid 18 in an area below the first pressure resistance portion 22 and above the second pressure resistance portion 24 according to the second embodiment. Fig. 7 is a pressure distribution diagram of the liquid 18 in an area below the second pressure resistance portion 24 and above the wafer 6 according to the second embodiment. Referring to Fig. 5, the number of the through holes 30 formed in the first pressure resistance portion 22 is equivalent to the number of the through holes 31 formed in the second pressure resistance portion 24. A pressure resistance applied to the liquid 18 passing through the second pressure resistance portion 24 near the wafer 6 is smaller than a pressure resistance applied to the liquid 18 passing through the first pressure resistance portion 22. More specifically, the hole diameter d4 is larger than the hole diameter d3.

Referring to Fig. 5, the hole diameter d3 of the through hole 30 is small in order to apply a large pressure resistance to the liquid 18 passing through the through hole 30. Thus, a flow amount of the liquid 18 passing through each of the through holes 30 is decreased, the liquid 18 is supplied to the entire buffer space 20, and the liquid 18 can be supplied evenly from the entire periphery of the supply port 12. However, if the hole diameter d3 is small, the flow rate of the liquid 18 passing through the through hole 30 is increased. Referring to Fig. 5, a pressure in the area below the first pressure resistance portion 22 becomes locally high at a position near the center of the through hole 30. Hence, the local high pressure may directly affect the wafer 6 and the wafer stage 7 unless the second pressure resistance portion 24 is provided. That is, if the second pressure resistance portion 24 is not provided, then a local deformation may appear at the wafer 6 and the wafer stage 7 likely causing a defocus during exposure, the stage control performance may be deteriorated, the flow of the liquid 18 in the space between the optical element 5 and the water 6 may be disordered, and an exposure defect may be increased accordingly.

In the exposure apparatus of this embodiment, the second pressure resistance portion 24 is arranged below the first pressure resistance portion 22, and the hole diameter d4 of the through hole 31 is relatively large. With this configuration, referring to Fig. 7, a difference between a pressure at a position near the center of the through hole 31 and a pressure at other position becomes extremely small in the area below the second pressure resistance portion 24. Accordingly, the local deformation hardly appears at the wafer 6 and the wafer stage 7, the stage control performance can be prevented from being deteriorated, and the turbulence of the flow of the liquid 18 in the space between the optical element 5 and the wafer 6 can be reduced. Hence, exposure of a desirable pattern can be provided.

The first and second pressure resistance portions 22 and 24 are described in more details. The first pressure resistance portion 22 applies a desirable large pressure resistance to the liquid 18 passing through the supply port 12, so as to supply the liquid 18 substantially evenly from the entire periphery of the supply port 12. To provide such a function, the hole diameter d3 of the through hole 30 of the first pressure resistance portion 22 is small. In contrast, since the first pressure resistance portion 22 applies the desirable high pressure to the liquid 18, the second pressure resistance portion 24 does not have to apply a high pressure to the liquid 18. The hole diameter d4 of the through hole 31 is large so that the liquid 18 discharged from the through hole 31 does not apply a local high pressure to the wafer 6 or the wafer stage 7 and the turbulence of the flow of the liquid 18 in the space between the optical element 5 and the wafer 6 is reduced.

Since the pressure resistance produced by the second pressure resistance portion 24 and applied to the liquid 18 is smaller than the pressure resistance produced by the first pressure resistance portion 22 (since the hole diameter d4 is larger than the hole diameter d3), the liquid 18 can be supplied substantially evenly from the entire periphery of the supply port 12. Further, the local deformation appearing at the wafer 6 and the wafer stage 7 can be reduced, the stage control performance can be prevented from being deteriorated, and the turbulence of the flow of the liquid 18 in the space between the optical element 5 and the wafer 6 can be reduced. Accordingly, exposure of a desirable pattern can be provided.

In the exposure apparatus of this embodiment, the through hole 30 formed in the first pressure resistance portion 22 and the through hole 31 formed in the second pressure resistance portion 24 are arranged so as not to be overlapped with each other in the direction perpendicular to the wafer 6. With this arrangement, referring to Fig. 5, the liquid 18 discharged from the through hole 30 hits the second pressure resistance portion 24, whereby a flow direction of the liquid 18 is changed, and the liquid 18 flows from the through hole 31 toward the wafer 6. This helps to prevent a phenomenon in which the liquid 18 passing through the through hole 30 directly hits the wafer 6 and the wafer stage 7 while the liquid 18 has a high speed (a local high pressure) and the liquid 18 affects the wafer 6 and the wafer stage 7. Moreover, two pressure resistance portions can further reliably provide different functions (including a function of supplying the liquid 18 substantially evenly from the entire periphery of the supply port 12, a function of reducing a local deformation appearing at the wafer 6 and the wafer stage 7, and a function of reducing a turbulence of the flow of the liquid 18).

In the exposure apparatus of this embodiment, the first pressure resistance portion 22, and the first spacer 23, the second pressure resistance portion 24 have substantially equivalent thicknesses (0.5 mm). The thickness of the supply port 12 is only about 1.5 mm. In such a small region, the pressure resistance can be adjusted to the desirable value, the local pressure applied to the wafer 6 and the wafer stage 7 can be reduced, and the turbulence of the flow of the liquid 18 can be reduced. Thus, the apparatus can be reduced in size.

The first pressure resistance portion 22, the first spacer 23, and the second pressure resistance portion 24 do not have to have equivalent thicknesses. For example, when the hole diameter d3 of the through hole 30 formed in the first pressure resistance portion 22 is relatively small (for example, about 0.05 mm), the thickness of the first pressure resistance portion 22 is desirably small in view of machineability. For example, the thickness may be about 0.2 mm. At this time, the thickness of the first pressure resistance portion 22 becomes smaller than the thicknesses of the.first spacer 23 and second pressure resistance portion 24. Even in this case, the liquid 18 can be supplied substantially evenly from the entire periphery of the supply port 12, the local deformation appearing at the wafer 6 and the wafer stage 7 can be reduced, the stage control performance can be prevented from being deteriorated, and the turbulence of the flow of the liquid 18 can be reduced. Processing becomes easier, and the apparatus can be reduced in size.

Further, in this embodiment, the first spacer 23 has the thickness of about 0.5 mm, however, the thickness of the first spacer 23 is not limited thereto as long as the first spacer 23 provides a gap that allows the liquid 18 to smoothly flow from the through hole 30 of the first pressure resistance portion 22 to the through hole 31 of the second pressure resistance portion 24. Thus, the first spacer may have a thickness of 0.1 mm or larger.

In this embodiment, the first spacer 23 is provided separately from the first and second pressure resistance portions 22 and 24, however, the first spacer 23 does not have to be separately provided. For example, a surface of the first pressure resistance portion 22 facing the second pressure resistance portion 24, or a surface of the second pressure resistance portion 24 facing the first pressure resistance portion 22 may have an integrally formed recess to serve as a spacer. Alternatively, the first pressure resistance portion 22, the first spacer 23, and the second pressure resistance portion 24 may be integrally formed and the integrated member may be provided at the supply port 12. This reduces the number of parts.

In the exposure apparatus of this embodiment, the number of the through holes 30 of the first pressure resistance portion 22 is equivalent to the number of the through holes 31 of the second pressure resistance portion 24, however, it is not limited thereto. The number of the through holes 30 may be smaller or larger than that of the through holes 31. For example, in order to shorten a fabricating process by using a common tool for boring the through holes, the hole diameter d3 of the through hole 30 may be equivalent to the hole diameter d4 of the through hole 31. In this case, to reduce the pressure resistance produced by the second pressure resistance portion 24 and applied to the liquid 18, the number of the through holes 31 may be larger than the number of the through holes 30. Accordingly, the flow rate of the liquid 18 passing through the through holes 31 is decreased. Hence, the pressure resistance produced by the second pressure resistance portion 24 and applied to the liquid 18 becomes smaller than the pressure resistance produced by the first pressure resistance portion 22. Accordingly, the local deformation appearing at the wafer 6 and the wafer stage 7 can be reduced, the stage control performance can be prevented from being deteriorated, and the turbulence of the flow of the liquid 18 in the space between the optical element 5 and the wafer 6 can be reduced. Alternatively, the hole diameter d4 of the through hole 31 may become larger than the hole diameter d3 of the through hole 30, and the number of the through holes 31 may become larger than the number of the through holes 30. In this case, the pressure resistance produced by the second pressure resistance portion 24 and applied to the liquid 18 becomes smaller than the pressure resistance produced by the first pressure resistance portion 22.

Next, a configuration in accordance with the second embodiment, in which the third pressure resistance portion 25 and the fourth pressure resistance portion 27 are provided at the recovery port 13, is described with reference to Fig. 8. Fig. 8 is an enlarged cross-sectional view showing an area near the recovery port 13 formed at the nozzle 19. Referring to Fig. 8, the number of the through holes 32 formed in the third pressure resistance portion 25 is equivalent to the number of the through holes 33 formed in the fourth pressure resistance portion 27. The third pressure resistance portion 25, the second spacer 26, and the fourth pressure resistance portion 27 have substantially equivalent thicknesses. A pressure resistance produced by the fourth pressure resistance portion 27 and applied to the liquid 18 is smaller than a pressure resistance produced by the third pressure resistance portion 25. More specifically, the hole diameter d6 is larger than the hole diameter d5.

Similarly to the supply port 12, the recovery port 13 includes the third pressure resistance portion 25 and the fourth pressure resistance portion 27 in order to recover the liquid 18 substantially evenly to the entire periphery of the recovery port 13, and to reduce the turbulence of the flow of the liquid 18 in the space between the optical element 5 and the wafer 6. By increasing the pressure resistance produced by the third pressure resistance portion 25 and applied to the liquid 18 (by decreasing the hole diameter d5 of the through hole 32), the liquid 18 can be recovered substantially evenly to the entire periphery of the supply port 12. Also, by decreasing the pressure resistance produced by the fourth pressure resistance portion 27 (by increasing the hole diameter d6 of the through hole 33), the flow rate of the liquid 18 passing through the through hole 33 can be decreased. Accordingly, referring to Fig. 8, the turbulence of the flow of the liquid 18 in the space between the optical element 5 and the wafer 6 can be reduced.

As described above, since the pressure resistance produced by the fourth pressure resistance portion 27 and applied to the liquid 18 is smaller than the pressure resistance produced by the third pressure resistance portion 25 (since the hole diameter d6 of the through hole 33 is larger than the hole diameter d5 of the through hole 32), the liquid 18 can be recovered substantially evenly to the entire periphery of the recovery port 13. Further, the turbulence of the flow of the liquid 18 can be reduced. Accordingly, exposure of a desirable pattern can be provided.

Moreover, similarly to the supply port 12, the thicknesses of the third pressure resistance portion 25, the second spacer 26, and the fourth pressure resistance portion 27 of the recovery port 13, as well as the hole diameter, number, positional relationship of the through holes are freely determined to obtain a desirable performance.

Similarly to the supply port 12, the third pressure resistance portion 25 and the second spacer 26, or the fourth pressure resistance portion 27 and the second spacer 26 may be integrally formed. Alternatively, the third pressure resistance portion 25, the second spacer 26, and the fourth pressure resistance portion 27 may be integrally formed.

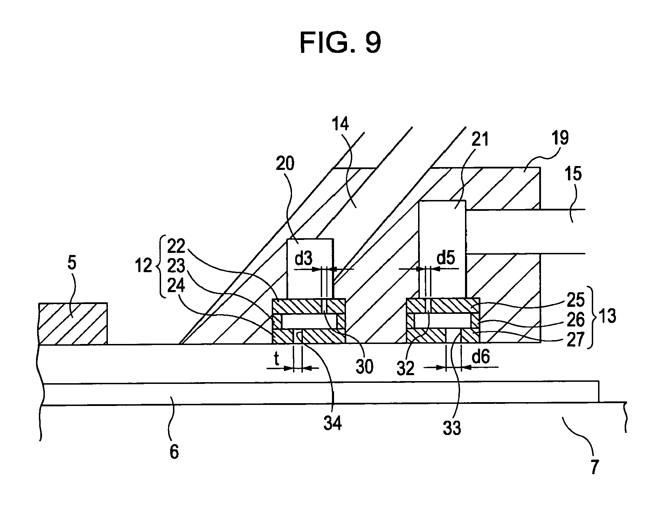

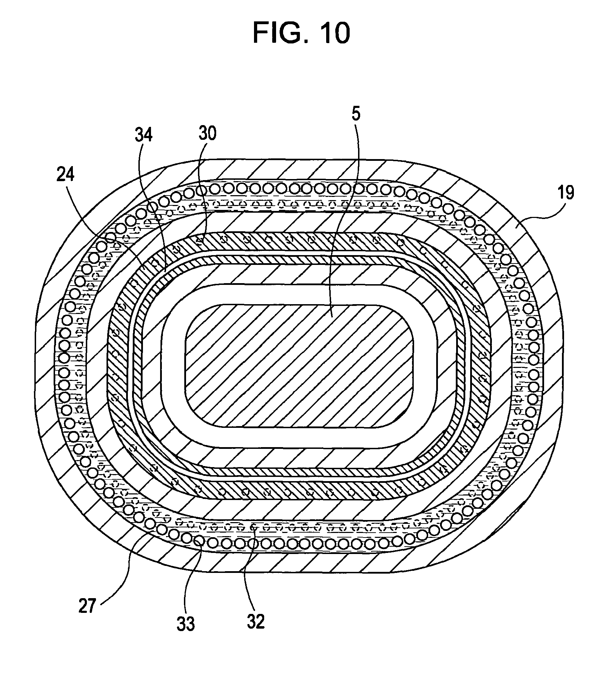

Next, another embodiment in accordance with the present invention is described with reference to Figs. 9 and 10. Fig. 9 is a configuration diagram showing an area near a supply port 12 and a recovery port 13 formed at a nozzle 19 of an exposure apparatus of this embodiment. Fig. 10 is a plan view showing a lower side of the nozzle 19 and an optical element 5 of the embodiment. In particular, Fig. 10 is a configuration diagram showing a positional relationship of pressure resistance portions 22, 24, 25, and 27 of the supply port 12 and the recovery port 13. The exposure apparatus of this embodiment is different from the exposure apparatus of the second embodiment in that the second pressure resistance portion 24 of the supply port 12 has a slit 34 instead of the through holes 31.

Referring to Fig. 9, the slit 34 has a slit width t, which is determined to a desirable value so that a local high pressure applied by liquid 18 discharged from the slit 34 to a wafer 6 and a wafer stage 7 can be reduced, and that the turbulence of the flow of the liquid 18 is reduced. In this embodiment, the slit width t is about 0.5 mm. Referring to Fig. 10, the slit 34 and through holes 30 are arranged so as not to be overlapped with each other when viewed from the lower side of the nozzle 19.

In the exposure apparatus of the third embodiment, similarly to the second embodiment, the first pressure resistance portion 22 applies a desirable large pressure resistance to the liquid 18 passing through the supply port 12, so as to supply the liquid 18 substantially evenly from the entire periphery of the supply port 12. In the second embodiment, the second pressure resistance portion 24 is formed of the porous plate with the plurality of through holes 31. In the third embodiment, the second pressure resistance portion 24 is formed of a slit plate. In the second embodiment, the through holes 31 are provided discretely around the optical element 5 (see Fig. 4). Hence, the liquid 18 is discretely supplied to the space between the optical element 5 and the wafer 6. This may cause bubbles to be mixed into the liquid 18. The exposure apparatus of the third embodiment addresses the bubble mixing. In particular, by forming the slit 34 instead of the through holes 31 in the second pressure resistance portion 24, the liquid 18 can be supplied continuously from the entire periphery of the supply port 12 surrounding the optical element 5 (see Fig. 10). Thus, the occurrence of the bubble mixing can be reduced.

When the slit plate is used as a pressure resistance portion in order to reduce the occurrence of the bubble mixing, to obtain a desirable pressure resistance, typically, the slit width has to be extremely small. However, if the slit width is small, difficulty in machining is increased, this may increase fabricating cost.

In the third embodiment, since the first and second pressure resistance portions 22 and 24 are arranged, the first pressure resistance portion 22 can produce the desirable large pressure resistance to the liquid 18, and hence, the second pressure resistance portion 24 does not have to produce the large pressure resistance. Accordingly, the slit width t of the second pressure resistance portion 24 can be large. Machining can be performed relatively easily, thereby preventing the cost from being excessively increased. The liquid 18 can be continuously and substantially evenly supplied from the entire periphery of the supply port 12. The turbulence of the flow of the liquid 18 can be further reduced, and the occurrence of the bubble mixing can be further reduced.

In the third embodiment, the slit 34 is provided in the second pressure resistance portion 24 of the supply port 12, however, a slit 34 may be alternatively or additionally provided in the fourth pressure resistance portion 27 of the recovery port 13. By providing the slit in the fourth pressure resistance portion 27 of the recovery port 13, the liquid 18 can be recovered continuously to the entire periphery of the recovery port 13. The occurrence of the bubble mixing can be further reduced.

In the second and third embodiments, the two pressure resistance portions are provided at the supply port 12 or the recovery port 13. However, three or more pressure resistance portions may be provided. By arranging three or more pressure resistance portions, the member, thickness, or the like, of each pressure resistance portion can be appropriately determined. When the porous plate is used as the pressure resistance portion, the hole diameter or number of the through holes, the positional relationship between the through holes of the two adjacent porous plates, and the like, can be further freely designed.

In the first, second, and third embodiments, the porous plates are provided as the first and third pressure resistance portions 22 and 25. However, the pressure resistance portions are not limited to the porous plates. For example, porous bodies or porous materials may be used. Members of the first and third pressure resistance portions 22 and 25 may be selected from any members as long as the pressure resistance portions can apply a desirable pressure resistance to the liquid 18.

Also, the porous plates of the supply port 12 and the recovery port 13 face each other, however, the plates do not have to face each other. When a supply port 12 and a recovery port 13 are curved with respect to the wafer 6, their porous plates may be distant from each other so that a sufficient pressure resistance is produced in a direction in which the liquid 18 flows through a passage.

Next, a manufacturing method of a device (semiconductor device, liquid crystal display device, etc.) according to an embodiment of the present invention is described. Here, a manufacturing method of a semiconductor device is described as an example.

The semiconductor device is manufactured through a front-end process in which an integrated circuit is formed on a wafer, and a back-end process in which an integrated circuit chip on the wafer formed in the front-end process is completed as a product. The front-end process includes a process of exposing a substrate with a photoresist applied thereon using the above-described exposure apparatus of the present invention, and a process of developing the substrate. The back-end process includes an assembly process (dicing and bonding), and a packaging process (sealing).

With the device manufacturing method of this embodiment, a device with higher quality can be manufactured as compared with an existing device manufacturing method.

While the present invention has been described with reference to various exemplary embodiments, it is to be understood that the invention is not limited to the disclosed exemplary embodiments. The scope of the following claims is to be accorded the broadest interpretation so as to encompass all modifications and equivalent structures and functions.

## Claims

1. An exposure apparatus arranged to expose a substrate (6) through liquid (18), the apparatus comprising:
a projection optical system (4) arranged to project a pattern of an original (2) onto the substrate;
a supply port (12) arranged to supply the liquid (18);
a recovery port (13) arranged to recover the liquid; and
a plurality of pressure resistance portions (22, 24, 25, 27) arranged at a passage of at least one of the supply port and the recovery port and arranged to apply pressure resistances to the liquid passing through the passage,
wherein the plurality of pressure resistance portions are arranged to surround a final surface of the projection optical system,
wherein the plurality of pressure resistance portions are distant from each other in a direction in which the liquid flows through the passage, and
wherein the pressure resistance portion which is included in the plurality of pressure resistance portions and is nearest to the substrate faces the substrate.

2. The exposure apparatus according to claim 1,
wherein the plurality of pressure resistance portions apply different pressure resistances to the liquid.

3. The exposure apparatus according to claim 2,
wherein the pressure resistance portion which is included in the plurality of pressure resistance portions and is nearest to the substrate applies a smaller pressure resistance to the liquid than a pressure resistance of other of the pressure resistance portions.

4. The exposure apparatus according to claim 1,
wherein the plurality of pressure resistance portions are a plurality of porous plates each having a plurality of through holes (28, 29, 30, 31, 32, 33).

5. The exposure apparatus according to claim 4,
wherein the porous plate which is included in the plurality of porous plates and is nearest to the substrate has through holes with a larger hole diameter than a hole diameter of through holes of other of the porous plates.

6. The exposure apparatus according to claim 4,
wherein the porous plate which is included in the plurality of porous plates and is nearest to the substrate has a larger number of through holes than the number of through holes of other of the porous plates.

7. The exposure apparatus according to claim 4,
wherein through holes of the two adjacent porous plates are arranged so as not to be overlapped with each other in a direction perpendicular to the substrate.

8. The exposure apparatus according to claim 1,
wherein the pressure resistance portion which is included in the plurality of pressure resistance portions and is nearest to the substrate is a slit plate having a slit (34) whereas at least one other pressure resistance portion is a porous plate having a plurality of through holes.

9. The exposure apparatus according to claim 8,
wherein the slit of the slit plate and the through holes of the porous plate adjacent to the slit plate are arranged so as not to be overlapped with each other in a direction perpendicular to the substrate.

10. The exposure apparatus according to claim 8,
wherein a plurality of the porous plates are provided, the through holes of the two adjacent porous plates being arranged so as not to be overlapped with each other in a direction perpendicular to the substrate.

11. A device manufacturing method comprising:
exposing a substrate (6) using the exposure apparatus according to claim 1; and
developing the exposed substrate.
